(19) Europäisches Patentamt
European Patent Office
Office européen des brevets

(11) Publication number: **0 609 848 A2**

(12) **EUROPEAN PATENT APPLICATION**

(21) Application number: **94101492.0**

(51) Int. Cl.5: **G03F 3/10**

(22) Date of filing: **01.02.94**

(30) Priority: **02.02.93 JP 15505/93**
**25.02.93 JP 36909/93**

(43) Date of publication of application:
**10.08.94 Bulletin 94/32**

(84) Designated Contracting States:
**DE FR GB NL**

(71) Applicant: **KONICA CORPORATION**
**26-2, Nishi-shinjuku 1-chome**
**Shinjuku-ku**
**Tokyo 163(JP)**

(72) Inventor: **Masumi, Satoshi, c/o Konica Corporation**
**28 Horinouchi**
**Odawara-shi, Kanagawa-ken(JP)**
Inventor: **Takada, Shun, c/o Konica Corporation**
**28 Horinouchi**
**Odawara-shi, Kanagawa-ken(JP)**
Inventor: **Okawauchi, Susumu, c/o Konica Corporation**
**28 Horinouchi**
**Odawara-shi, Kanagawa-ken(JP)**

(74) Representative: **Henkel, Feiler, Hänzel & Partner**
**Möhlstrasse 37**
**D-81675 München (DE)**

(54) **Method for making color proof using silver halide color photographic light-sensitive material.**

(57) A method for making a color proof using a silver halide color photographic light-sensitive material is disclosed. In the light-sensitive material to be used in the method, the ratios of the blue-light sensitivity of the blue sensitive layer to that of the green-sensitive layer and to that of the red-sensitive layer of the light-sensitive material are each not lower than 1/10, and the gradient of the yellow image formed in the light-sensitive material is 1.7 to 2.8 after processing.

EP 0 609 848 A2

## FIELD OF THE INVENTION

The present invention relates to a method for a color proof using a silver halide color photographic light-sensitive material, articulately relates to a method for making a color proof from a color separation black-and-white dot image, formed on a transparent support, formed from a color image to be printed.

## BACKGROUND OF THE INVENTION

To date in the steps of color plate making or printing, as a method of overcoming drawbacks in the overlay process or the surprint process, which have been used for obtaining a color proof from a plurality of black-and-white dot images, a method of using a silver halide light-sensitive color photographic material has been proposed in, for example, Japanese Patent O.P.I. Publications No. 62- 280747 (19870 through -280750(1987) and 62-280849(1987).

Moreover, a method of obtaining a color proof with excellent color reproduction property by using a specific yellow-dye-forming coupler is disclosed in Japanese Patent O.P.I. Publication No. 1-298092(1989).

However, demand for quality requirement in the market has been elevated and the field in which the use of concerned technology is required has been expanded.

Dot gain is one of important characteristics which exerts on the picture quality in the printed matter and the requirement for the dot gain is different depending on the kind of printing.

The dot gain can be adjusted by controlling exposure in the color proof making process in which a silver halide color photographic light-sensitive material is used, however, when the exposure is changed, color hue is also changed and thus deteriorates color reproduction property. Especially, deterioration of yellow dye image is remarkable. Accordingly, a color proof making method using a silver halide light-sensitive material, which has less hue change by the change of the exposure, has been a demand.

## SUMMARY OF THE INVENTION

The object of the present invention is, therefore, to provide a method for making a color proof using a silver halide color photographic light-sensitive material, which causes less deterioration in the image quality upon production of a color proof from dot image information obtained from color separation and dot image conversion processes of a dye image formed in a silver halide light-sensitive color photographic material.

The method of the invention for making a color proof comprises the steps of

dot-imagewise exposing a silver halide color photographic light-sensitive material comprising a reflective support having thereon a blue-sensitive silver halide emulsion layer containing a yellow color forming coupler, a green-sensitive silver halide emulsion layer containing a magenta color forming coupler and a red-sensitive silver halide emulsion containing a cyan color forming coupler, to blue-light to form a yellow halftone dot image, and

developing the exposed light-sensitive material with a color developer,

wherein the sensitivity to the blue-light of the green-sensitive emulsion layer $(S_G)_B$ and that of the blue-sensitive emulsion layer $(S_B)_B$, and the sensitivity to the blue-light of the red-sensitive emulsion layer $(S_R)_B$ and that of the blue-sensitive emulsion layer $(S_B)_B$ each have the following relation,

$(S_G)_B/(S_B)_B \leqq 1/10$ and $(S_R)_B/(S_B)_B \leqq 1/10$, and

the gradient $G_1$ of a straight line connecting a density point of (minimum density + 0.5) and a density point of (minimum density + 1.1) on the photographic characteristic curve of the yellow image formed on the light-sensitive material processed by the above processing is within the range of from 1.7 to 2.8.

It is preferable that the photographic characteristic curve of the yellow image further has a gradient $G_2$ of a straight line connecting a density point of (minimum density + 1.4) and a density point of (minimum density + 1.7) on the curve is not lower than 1.8.

The blue-light and the processing used for determining the above $(S_B)_B$, $(S_G)_B$, $(S_R)_B$, $G_1$ and $G_2$ are the same as those used for exposing and processing to make the yellow dot image of the color proof.

## DETAILED DESCRIPTION OF THE INVENTION

In the present invention, the above gradient $G_1$ is defined to be the gradient of a straight line connecting point a of (the minimum density + 0.5), and a point b of (the minimum density + 1.1) on the photographic characteristic curve, i.e., density vs. Log E curve, of a silver halide color photographic light-sensitive material (hereinafter referred as simply a light-sensitive material) after processing. Further, gradient $G_2$ defined to be the gradient of a straight line connecting point c of (the minimum density + 1.4) and point d of (the minimum density + 1.7) on the characteristic curve.

In other words, the gradients $G_1$ and $G_2$ are each given by the following equations:

$$G_1 = 0.6/(\log E_b - \log E_a)$$
$$G_2 = 0.3/(\log E_d - \log E_c)$$

In the above, $E_a$, $E_b$, $E_c$ and $E_d$ are each the exposure amounts corresponding to the density points of a, b, c and d, respectively.

The gradient can be measured on the characteristic curve of yellow image formed in a light-sensitive material to be used by an ordinary procedure of sensitometry, in which a test piece of the light-sensitive material is exposed to blue light through an ordinary optical wedge and processed. The light and the processing in the above are the same as those to be used for making the color proof.

In the method for making a color proof of the invention, the characteristic curves of the yellow image formed in the light-sensitive material has an average gradient $G_1$ of 1.7 to 2.8, preferably 2.0 to 2.6. Dot gain control of the yellow image can be easily carried out when the gradient of each of light-sensitive layers is made to be within the above specified range. It is further preferable that the gradient $G_2$ of the yellow is 1.8 or more. It is unexpected that the dot gain control ability without degradation in the color in the process of color proof making is remarkably raised by making the gradient $G_1$ to the above specified value.

The above mentioned dot gain is a value given by the following equation:

Dot Gain = (Percentage of dots in a printed image) - (Percentage of dots of a original dot image)

The percentage of dots of a printed image, i.e., appearance of dot area (ADA) is given by the following Murry-Davies equation:

$$ADA = (1-10^{-Dt})/(1-10^{-Ds})$$

in the above,
Dt = (Optical density of the dot image) - (Optical density of white background of the image)
Ds = (Optical density of the solid image) - (Optical density of white background of the image).

The above percentage of dots of the printed image is read as the percentage of dots of color proof in the process of the color proof making of the invention.

In actual printing processes, the dot gain is usually about 22 % in the yellow image, i.e., a printed image corresponding to an original separation image having a dots percentage of 50 % has dot percentage of 72 % on the printed paper in the case of yellow printed image. Accordingly, it is required that the dot gain of 22 % to be made in the color proof making process using a silver halide photographic material. In other words, a color proof image printed from a original image having a dot percentage of 50 % should be have a dot percentage of 72 %. In the proof making process, the dot gain is controlled by changing exposure so as to making the dot gain of 22 % in yellow image in the color proof.

To adjust the gradient of the light-sensitive layer of the light-sensitive material to be used in the invention to the specified value, various factor of the light-sensitive material such as the coating weight of silver halide, amount ratio of silver halide to coupler, amount of optical sensitizing dye, chemical sensitization of the emulsion, amount of development inhibitor and mixing of plural kinds of emulsion different in the sensitivity from each other, can be controlled.

As the silver halide used for the light-sensitive material of present invention, any arbitrary one used in the conventional silver halide emulsion in the photographic field including, for example, silver bromide, silver iodobromide, silver iodochloride, silver chlorobromide, and silver chloride can be used.

In the light-sensitive material to be used in the method of the invention, the silver halide composition inside the silver halide grain used in the present invention may either be uniform or different from the center to outer surface of the grain.

There is no specific limitation as to the size of the silver halide grain used in the present invention, however, in view of other photographic performances such as adaptability to rapid process, sensitivity, 0.2 to 1.6 $\mu$m is preferable, and range between 0.25 to 1.2 $\mu$m is further preferable.

As to size distribution may be so-called poly-dispersion or mono-dispersion.

Preferable size distribution of silver halide grains may be 0.22 or less, in terms of coefficient of variation and, more preferably, 0.15 or less. Herein, the coefficient of variation is given in the following equation:

Coefficient of Variation = (Standard Deviation)/(Average grain size)

Such monodisperse emulsion may be used either singly or mixed with another monodisperse emulsion. Use of the mixed emulsion is preferable.

The silver halide grain used in the present invention may be anyone obtained through either acid process, neutral process, or ammoniacal process and the grain can be grown either at one time or stepwise, for example, after making seed grain. It is a preferable method in which seed grains are formed and the seed grains are grown under an acidic condition.

As to the manner of reacting a soluble silver salt with a soluble halide salt to precipitate the silver halide grain used in the present invention, either one of normal precipitation method, reverse precipitation method or double-jet mixing method, and any combination thereof may be employed. Among these methods, one prepared through double-jet mixing method is preferable.

As for the crystal shape of the silver halide grains used in the present invention, any arbitrary shape may be used. One preferable example is a cubic shaped grain which has a surface consisting of {100} planes.

Moreover, the grains having various shapes such as octahedron, tetradecahedron, dodecahedron, and the grains having twinned planes may also be used. The grains employed in the emulsion may consist of either single kind or two or more kinds in combination.

The silver halide grain used in the silver halide emulsion of present invention, can be incorporated, during the step of crystal formation or growth thereof, with a metallic ion by using ,for example, a cadmium salt, a zinc salt, a lead salt, a thallium salt, an iridium salt including a complex salt thereof, a rhodium salt including a complex salt thereof, an iron salt including a complex salt thereof, either inside or on the surface of the grain.

It is also preferable to confer sensitization specks inside or on the surface of the grain by putting the grain in the reductive atmosphere.

After completion of the crystal growth of the silver halide grain, unnecessary soluble salts are usually removed from the system, or they may be made remained in the emulsion. Removal of the unnecessary salts may be carried out according to the method disclosed, for example, in the Research Disclosure No. 17643.

The silver halide grain may be either a type as to which latent image is mainly formed on the surface or a type it is mainly formed inside thereof. In the present invention the former is preferable.

The silver halide emulsion used in the present invention can be sensitized by a chemical sensitization such as sulfur sensitization, gold sensitization, noble metal sensitization, selenium sensitization or reduction sensitization, and can be spectrally sensitized with a optical sensitizer such as a cyanine dye, merocyanine dye, hemicyanine dye, styryl dye and hemioxonol dye, according to the conventional method. Moreover, into the silver halide emulsion used in the present invention, other photographic additives such as a fog restrainer, a stabilizing agent such as azaindene or mercapto heterocyclic compounds may also be added.

The Silver halide emulsion can be used either singly or two or more kinds in combination. However, in the present invention, the latter is more preferable.

The sensitivity of blue light of a blue light-sensitive layer of the color light-sensitive material to be used in the present invention, a green light-sensitive layer, and a red-sensitive layer is represented as follows.

$S_G/S_B \leqq 1/10$ $S_R/S_B \leqq 1/10$

$S_B$: Blue photosensitivity of blue light-sensitive layer
$S_G$: Blue photosensitivity of green light-sensitive layer
$S_R$: Blue photosensitivity of red light-sensitive layer

The sensitivity of each layer are expressed by reciprocal of the exposure amount necessary for making a density of (Dmin + 0.5) in each light-sensitive layer. Blue light for measurement of the sensitivity is the same as the foregoing "blue light" used for determination of $G_1$ and $G_2$.

As the above blue light, light having a continuous energy distribution or a bright line within the range of 350 to 500 nm may either be used.

As light source for exposure, natural light, a tungsten lump, a fluorescent lump, a mercury lump, a halogen lump and a laser can be used. The fluorescent lump is particularly preferable by reason of lower heat generation and the miniaturization of the exposure equipment in the scanning exposure.

Exposure method for making a color proof includes a photographing method using an optical system and a contact exposing method. The contact exposing method is preferable in which the light-sensitive material is exposed to light through a film having color separation dot images contacted to the light-sensitive material. In the present invention, the above blue light is used for exposing to make a yellow image on the proof.

There are the following in a typical method for making the blue sensitivity difference between the blue-sensitive layer and the green- or red-sensitive emulsion layer:

1) The sensitivity of the blue light-sensitive emulsion is raised.

2) The inherent sensitivities to blue light of the green-and red-sensitive emulsions are lowered.

3) A filter layer is provided between the blue-sensitive layer and the green- and red-sensitive layers.

The first method can be realized by means of the method such as increasing the amount of optical sensitizer, increasing the amount of chemical sensitizer or enlarging the grain size in the blue sensitive emulsion.

The second method includes the method such as adopting a high chloride emulsion for the green light-sensitive layer and the red light-sensitive layer.

As the third method, the blue light-sensitive layer is provided from the support to the distance from other light-sensitive layers, and a yellow filter comprising a yellow coloring material such as yellow colloidal silver is provided between the blue sensitive emulsion layer and the other emulsion layers.

When the sensitivity difference is extremely enlarged by the first method, the whiteness of background and the is developability are deteriorated. In the third method, sensitivity as the light-sensitive material falls. The method second from these is preferable. A high chloride emulsion more than silver chloride content 80 mol % is used. Although the blue light-sensitive layer need not use a high chloride emulsion, it is preferable to use a high chloride emulsion in the point that making to rapid processing becomes capable.

The above first to third methods are applied singly or in combination.

The dyestuff, which has absorption in various wave length areas in the object of anti-irradiation, can be used for the light-sensitive material in the present invention.

Any compound may be used in the light-sensitive material used in the invention as a coupler, which is capable of forming a coupling product having a light absorption peak within the region of the spectrum not shorter than 340 nm by coupling reaction with capable of forming a coupling products Coupler used for the light-sensitive material in the present invention. Especially, the coupler includes a yellow dye-forming coupler having the spectral absorption peak in wave length region 350-500 nm, a magenta color-forming coupler having the spectral absorption peak in wave length region 500-600 nm and a cyan color-forming coupler having the spectral absorption peak in wave length region 600-750 nm.

As cyan dye-forming couplers which can be used preferably in the light-sensitive material used in the present invention, those disclosed on page 17 of Japanese Patent O.P.I. Publication No. 4-114152 (1992) by formula (C-I) and (C-II) can be mentioned. As specific compounds, those disclosed on pages 18 through 21 as CC-1 through CC-9 can be mentioned.

The couplers disclosed on page 12 of Japanese Patent O.P.I. Publication No. 4-114152(1992) by formula (M-I) can be given as magenta couplers which can be used preferably in the light-sensitive material in the present invention.

Specific compounds are those disclosed on pages 13 through 16 of the specification as (MC-1) - (MC-7).

The coupler represented to specification page 8 of Japanese Patent O.P.I. No. 4-114152 (1992) issues by formula (Y-I) of the description can be given as a yellow-dye-forming coupler which can be used preferably to the light-sensitive material in the present invention. As for the yellow dye-forming coupler which is preferably used in the present invention, those disclosed on page 8 of Japanese Patent O.P.I. Publication No. 4-114152 (1992) as formula(Y-I) can be mentioned. More specifically, those disclosed on pages 9 through 11 as YC-1 through YC-9 can be mentioned. Among these YC-8 and YC-9 disclosed on page 11 of the specification are advantageous in the view that they can reproduce yellow dye of a preferable tone. Particularly preferable yellow coupler to be used in the light-sensitive material in the invention is ones represented by the following formula Y:

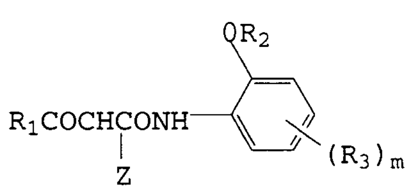

(Y)

wherein $R_1$ is an alkyl group or a cycloalkyl group; $R_2$ is an alkyl group, a cycloalkyl group or an aryl group; $R_3$ is a group capable of being a substituent of the benzene ring; m is an integer of 0 to 4; provided $R_3$s may be the same or different when m is 2 to 4; and Z is a hydrogen atom or a substituent capable of releasing upon reaction with the oxidation product of a color developing agent.

In the above formula, an alkyl group represented by $R_1$ includes a straight and branched chain alkyl group such as methyl group, ethyl group, i-propyl group, t-butyl group, n-dodecyl group and 1-hexylnonyl group. A cycloalkyl group represented by $R_1$ includes cyclopropyl group, cyclohexyl group and adamantyl group. The alkyl group and cycloalkyl group represented by $R_1$ may have a substituent. The substituent includes, for example, a halogen atom such as chlorine and bromine; a cyano group; a nitro group; an aryl group such as phenyl group, p-t-octylphenyl group, 2,4-di-t-amylphenyl group; a hydroxyl group; an alkoxyl group such as methoxy group and 2-ethoxyethoxy group; an aryloxy group such as phenoxy group, 2,4-di-t-amylphenoxy group and 4-(4-hydroxyphenylsulfonyl)phenoxy group; a heterocycloxy group such as 4-pyridyloxy group and 2-hexahydropyranyloxy group; a carbonyloxy group including an alkylcarbonyloxy group such as acetyloxy group and pivalyloxy group, and an arylcarbonyloxy group such as benzoyloxy group; a sulfonyloxy group including an alkylsulfonyloxy group such as methanesulfonyloxy group, trifluoromethanesulfonyloxy group, and n-dodecanesulfonyloxy group, and an arylsulfonyloxy group auch as benzenesulfonyloxy group and p-toluenesulfonyloxy group; a carbonyl group including an alkylcarbonyl group such as acetyl group and pivaloyl group, and an arylcarbonyl group such as benzoyl group and 3,5-di-t-butyl-4-hydroxybenzoyl group; an oxycarbonyl group including an alkoxycarbonyl group such as methoxy carbonyl group, cyclohexyloxycarbonyl group and n-dodecyloxycarbonyl group, an aryloxycarbonyl group such as phenoxycarbonyl group and 2,4-di-t-amylphenoxycarbonyl group, and a heterocycloxycarbonyl group such as 2-pyridyloxycarbonyl groupand 1-phenylpyrazolyl-5-oxycarbonyl group; a carbamoyl group including an alkylcarbamoyl group such as dimethylcarbonyl group and 4-(2,4-di-t-amylphenoxy)butylaminocarbonyl group, and an arylcarbonyl group such as phenylcarbamoyl group and 1-naphthylcarbamoyl group; a sulfonyl group including an alkylsulfonyl group such as methanesulfonyl group and trifluoromethanesulfonyl group, and an arylsulfonyl group such as p-toluenesulfonyl group; a sulfamoyl group including an alkylsulfamoyl group such as dimethylsulfamoyl group, 4-(2,4-di-t-amylphenoxy)-butylaminosulfonyl group, an arylsulfamoyl such as phenylsulfamoyl group, and an acylsulfamoyl group such as acetylsulfamoyl group and ethylcarbonylaminosulfonyl group; an amino group including an alkylamino group such as dimethylamino group, cyclohexylamino group and n-dodecylamino group, and an arylamino group such as anilino group and p-t-octylanilino group; a sulfonylamino group including an alkylsulfonylamino grop such as methanesulfonylamino group, heptafluoropropanesulfonylamino group and n-hexadecylsulfonylamino group, and an arylsulfonylamino group such as p-toluenesulfonylamino group and pentafuluorobenzenesulfonylamino group; an acyl amino group including an alkylcarbonylaminog roup such as acetylamino group and myristoylamino group, and an arylcarbonylamino group such as benzoylamino group; an alkylthio group such as methylthio group and t-octylthio group; an arylthio group such as phenylthio group; and a hetrocyclothio group such as 1-phenyltetrazole-5-thio group and 5-methyl-1,3,4-oxydiazole-2-thio group.

$R_1$ is preferably an alkyl grou, more preferably a branched alkyl group, further preferably t-butyl group.

As an alkyl group and a cycloalkyl group represented by $R_2$ in formula Y, for instance, an alkyl group and a cycloalkyl group the same as those represented by $R_1$ in formula Y can be cited. An aryl group represented by $R_2$ includes, for example, phenyl group and 1-naphthyl group. The above alkyl group, cycloalkyl group and aryl group represented by $R_2$ each may have a substituent. The substituent includes, for example, an alkyl group and cycloalkyl group the same as those represented by $R_1$, and the above mentioned groups as the substituent of the alkyl group or cycloalkyl group represented by $R_1$.

$R_2$ is preferably an alkyl group, more preferably an unsubstituted alkyl group, further preferably methyl group.

The group capable of being a substituent of the benzene ring of formulas Y may be a group, for example, the same as the group mentioned as the substituent of alkyl group cycloalkyl group and aryl group each represented by $R_2$ in formula Y.

$R_3$ is preferably an acylamino group, a sulfonylamino group, an oxycarbonyl group or a sulfamoyl group.

In formula Y, m is an integer of 0 to 4 and $R_3$s may be the same or different when m is 2 to 4. It is preferable that m is 1.

In formula Y, Z is a hydrogen atom or a substituent, capable of releasing upon reaction with the oxidation product of a color developing agent which includes groups represented the following formula X, XI or XII:

$-OR_4$ (X)

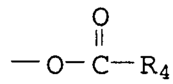 (XI)

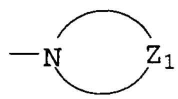 (XII)

In the above formulas X and XI, $R_4$ is an alkyl group, a cycloalkyl group, an aryl group or a heterocyclic group. The above alkyl group, cycloalkyl group and aryl group may be the same as those represented by $R_2$ in formula Y. The heterocyclic group represented by $R_4$ includes 4-pyridyl group and 2-hexahydropyranyl group. The alkyl group, cycloalkyl group, aryl group and heterocyclic group each may have a substituent. As the substituent, the groups cited above as the substituent for the alkyl group, cycloalkyl group and aryl group represented by $R_2$ in formula Y. Among these alkyl group, cycloalkyl group, aryl group and heterocyclic group, the aryl group is preferable. As the substituent of $R_4$. am electron attractive group is preferable. The electron attractive group includes an oxycarbonyl group such as a carboxyl group, methoxycarboxyl group and i-propyloxycarbonyl group; an acyl group such as benzoyl group; a sulfonyl group such as hydroxyphenylsulfonyl group; a nitro group; a cyano group; a halogen atom; a sulfamoyl group such as dimethylsulfamoyl group; an acyl group such as acetylamino group and pentafluorobenzoyl group; a sulfonylamino group such as acylamino group and methanesulfonylamino group.

In the above formula XII, $Z_1$ is a group of non-metal atoms necessary to form a 5- or 6-member ring together with the nitrogen atom, such as a methylene group, a methine group, a substituted methine group, $>C=O$, $>N-R_5$, $-N=$, -O-, and $-S(O)_u-$, in which $R_5$ is a hydrogen atom, an alkyl group, an aryl group or a heterocyclic group; and u is an integer of 0 to 2.

Among compounds represented by formula Y, ones represented by the following formula XIII are preferable.

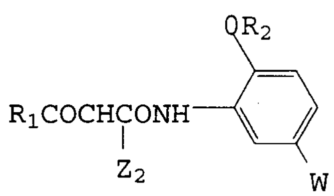 (XIII)

In the above formula XIII, groups represented by $R_1$ and $R_2$ are each the same as those represented by $R_1$ and $R_2$ in formula Y.

W is a group represented by the following formula XIV;

$$-NH-X-(L-Y)_n-R_6 \qquad (XIV)$$

In the above formula XIV, X is a carbonyl group or a sulfonyl group, and the carbonyl group is preferable. L is an alkylene group or an arylene group including a straight or branched alkylene group such as methylene group, ethylene group, 2,3-propylene group and 1,2-cyclohexylene group, and an arylene group such as 1,4-phenylene group, 1,2-naphthylene group and 9,10-anthranylene group. Among them, an alkylene group having 1 to 6 carbon atoms is preferable.

In formula XIV, Y is a two-valence bonding group such as a sulfinyl group, a sulfenyl group, a sulfonyl group, a sulfamoyl group, a carbonyl group, a carbonyloxy group, a carbamoyl group, an oxy group, an oxycarboyl group, an amino group, an acyl group and sulfonylamino group. Among these bonding groups, a sulfonyl group, a sulfamoyl group, a carbonyloxy group, a carbamoyl group, an oxy group, an oxycarbonyl group and an acylamino group are preferable, and a sulfonyl group, an oxy group, an oxycarbonyl group and a carbamoyl group are particularly preferable.

In formula XIV, n is 0 or 1.

In formula XIV, $R_6$ is an alkyl group, a cycloalkyl group or an aryl group. As the above groups represented by $R_6$, an alkyl group, a cycloalkyl group and an aryl group each represented by $R_2$ in formula Y can be cited. The alkyl group, cycloalkyl group and aryl group each represented by $R_6$ may have a substituent. As the substituent, those mentioned as the substituent of the alkyl group, cycloalkyl group or aryl group represented by $R_2$ in formula Y.

Preferable substituents represented by $Z_2$ in formula XIV are ones represented by the following formula XV, XVI, XVII, XVIII, XIX or XX:

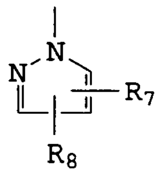

(XV)

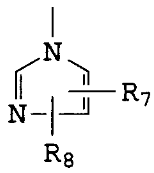

(XVI)

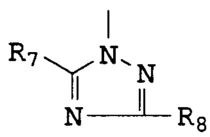

(XVII)

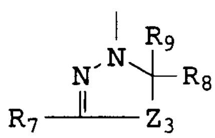

(XVIII)

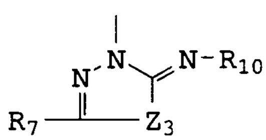

(XIX)

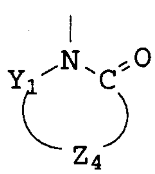

(XX)

In the above formulas XV through XX, $R_7$, $R_8$ and $R_9$ are each a group capable of substituted on the azole ring such as an alkyl group, an cycloalkyl group and an aryl group the same as those cited as the substituent of the group represented by $R_2$ in formula Y.

In the above formula XIX, $R_{10}$ is, for example, an alkyl group, an cycloalkyl group or an aryl group the same as those represented by $R_4$ in formulas X and XI, a crabonyl group or sulfonyl group.

The above formulas XVIII and XIX, $Z_3$ is >N-$R_{11}$, -O- or -S(O)$_v$-, in which $R_{11}$ is group the same as that represented by $R_5$ in formula XII and v is 0 to 2.

In the above formula XX, $Y_1$ is a hetero atom of >N-$R_{12}$, -O- or S(O)$_r$-, or a carbon atom of >C=O, >C-($R_{13}$)($R_{14}$) or >C($R_{15}$)-, in which $R_{12}$ is group the same as that represented by $R_5$ in formula XII, $R_{13}$, $R_{14}$ and $R_{15}$ are each a hydrogen atom or a group the same as that mentioned as the substituent of the alkyl group, cycloalkyl group or aryl group represented by $R_2$ in formula Y.

In formula XX, $Z_4$ is a group of non-metal atoms necessary for forming a 5- or 6-member ring together with $-Y_1-N-CO-$ in the formula. As the non-metal atom group, groups the same as those represented by $Z_1$ in formula XII.

A two-equivalent coupler represented by formula Y may be linked to form a bis-, tris-, tetrakis-compound or polymer at any substituent thereof.

Yellow couplers represented by formula Y can be synthesized by well-known methods such as those described in Japanese Patent O.P.I. Publication 63-123047 (1988) and Japanese Patent Application 2-245949 (1990) using compounds easily available on the market as raw materials.

Examples of releasing group Z of formula Y are given below.

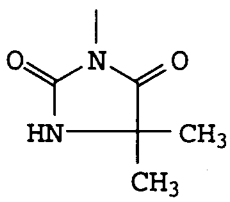
(A)

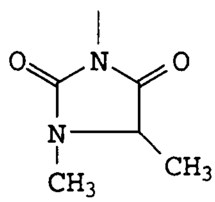
(B)

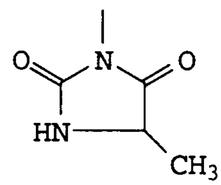
(C)

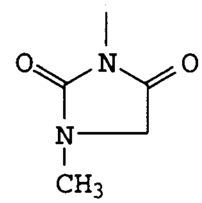
(D)

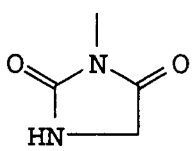
(E)

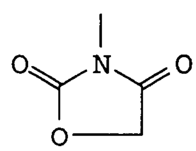
(F)

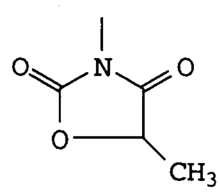
(G)

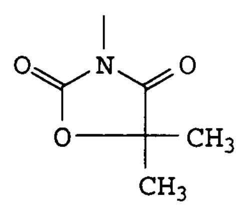
(H)

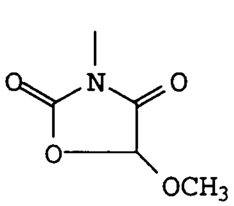
(I)

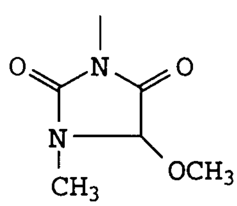
(J)

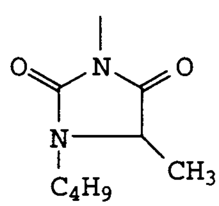
(K)

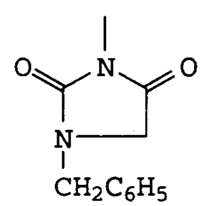
(L)

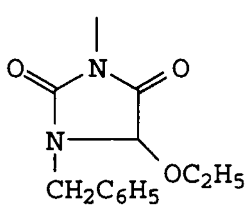
(M)

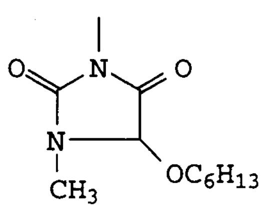
(N)

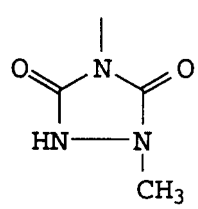
(Q)

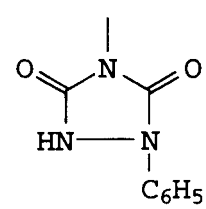
(P)

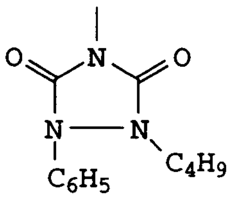

(Q)

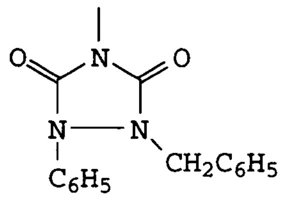

(R)

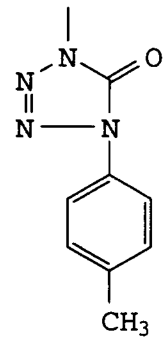

(S)

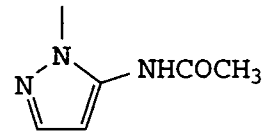

(T)

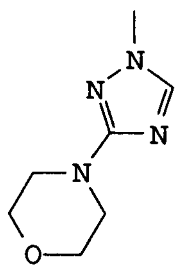

(U)

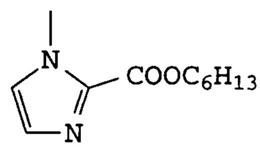

(V)

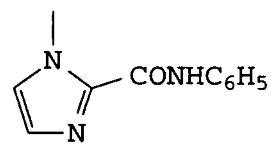

(W)

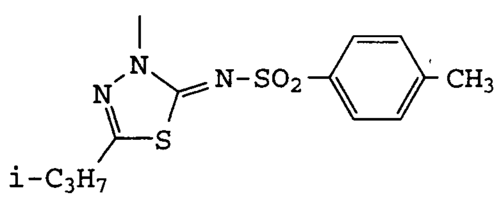

(X)

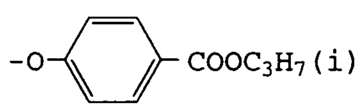

(Y)

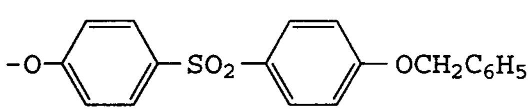

(Z)

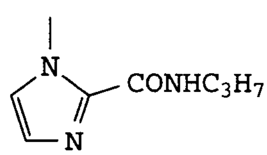

(α)

The examples of substituents represented by $R_3$ of formula Y are as follows:

$NHCOC_{11}H_{23}(n)$

(a)

$-NHCOC_{13}H_{27}(n)$

(b)

$-NHCOC_{15}H_{31}(n)$

(c)

$NHCOC_{17}H_{35}(n)$

(d)

$-NHCOC_{19}H_{39}(n)$

(e)

$-NHCOC_{21}H_{43}(n)$

(f)

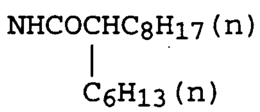

(g)

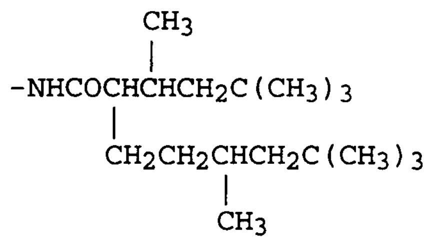

(h)

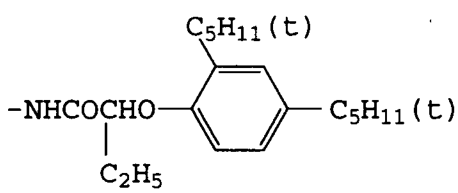

(i)

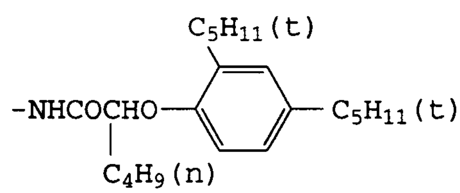

(j)

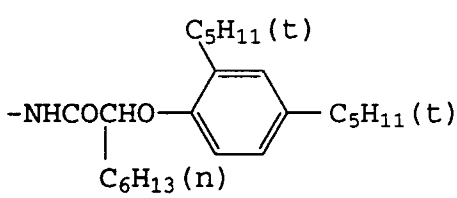

(k)

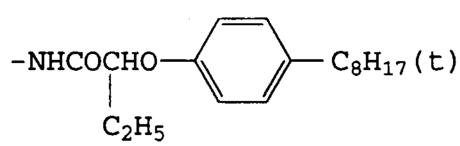

(l)

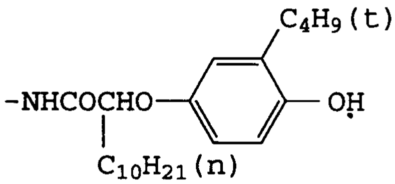

(m)

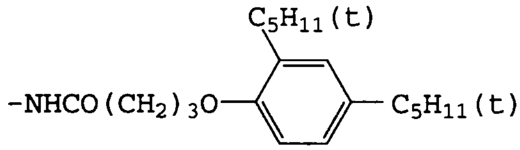

(n)

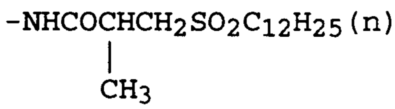

(o)

$-NHCO(CH_2)_3SO_2C_{12}H_{25}(n)$

(p)

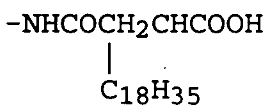

(q)

$-NHCOCH_2CH_2COOC_{12}H_{25}(n)$

(r)

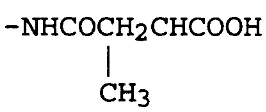

(q)

$-NHCOCH_2CH_2COOC_{12}H_{25}(n)$

(r)

$-NHSO_2C_{12}H_{25}(n)$

(s)

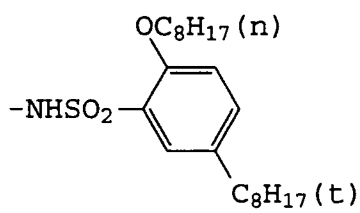

(t)

$-COOC_{14}H_{29}(n)$

(u)

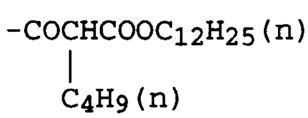

(v)

$-CONHC_{14}H_{29}$

(w)

$-SO_2NHCOC_2H_5$

(x)

2-exquivalent couplers of formula Y are given below.

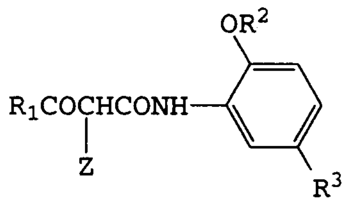

| No. | $R_1$ | $R_2$ | $R_3$ | Z |
|---|---|---|---|---|
| (1) | $t-C_4H_9$ | $CH_3$ | (d) | (A) |
| (2) | $t-C_4H_9$ | $CH_3$ | (c) | (A) |
| (3) | $t-C_4H_9$ | $CH_3$ | (d) | (B) |
| (4) | $t-C_4H_9$ | $CH_3$ | (d) | (D) |
| (5) | $t-C_4H_9$ | $CH_3$ | (f) | (E) |
| (6) | $t-C_4H_9$ | $CH_3$ | (d) | (G) |
| (7) | $t-C_4H_9$ | $CH_3$ | (h) | (H) |
| (8) | $t-C_4H_9$ | $CH_3$ | (c) | (L) |
| (9) | $t-C_4H_9$ | $CH_3$ | (g) | (H) |
| (10) | $t-C_4H_9$ | $CH_3$ | (i) | (H) |
| (11) | $t-C_4H_9$ | $CH_3$ | (k) | (H) |
| (12) | $t-C_4H_9$ | $CH_3$ | (i) | (A) |
| (13) | $t-C_4H_9$ | $CH_3$ | (j) | (A) |
| (14) | $t-C_4H_9$ | $CH_3$ | (l) | (A) |
| (15) | $t-C_4H_9$ | $CH_3$ | (i) | (N) |
| (16) | $t-C_4H_9$ | $CH_3$ | (h) | (N) |
| (17) | $t-C_4H_9$ | $CH_3$ | (n) | (L) |
| (18) | $t-C_4H_9$ | $CH_3$ | (e) | (M) |
| (19) | $t-C_4H_9$ | $CH_3$ | (j) | (J) |

| No. | $R_1$ | $R_2$ | $R_3$ | Z |
|---|---|---|---|---|
| (20) | $t-C_4H_9$ | $CH_3$ | (m) | (A) |
| (21) | $t-C_4H_9$ | $CH_3$ | (o) | (A) |
| (22) | $t-C_4H_9$ | $CH_3$ | (p) | (P) |
| (23) | $t-C_4H_9$ | $CH_3$ | (d) | (P) |
| (24) | $t-C_4H_9$ | $CH_3$ | (d) | (Q) |
| (25) | $t-C_4H_9$ | $CH_3$ | (o) | (Q) |
| (26) | $t-C_4H_9$ | $CH_3$ | (r) | (K) |
| (27) | $t-C_4H_9$ | $CH_3$ | (o) | (K) |
| (28) | $t-C_4H_9$ | $CH_3$ | (a) | (S) |
| (29) | $t-C_4H_9$ | $CH_3$ | (g) | (T) |
| (30) | $t-C_4H_9$ | $CH_3$ | (k) | (T) |
| (31) | $t-C_4H_9$ | $CH_3$ | (n) | (U) |
| (32) | $t-C_4H_9$ | $CH_3$ | (g) | (W) |
| (33) | $t-C_4H_9$ | $CH_3$ | (l) | (W) |
| (34) | $t-C_4H_9$ | $CH_3$ | (i) | (X) |
| (35) | $t-C_4H_9$ | $CH_3$ | (u) | (N) |
| (36) | $t-C_4H_9$ | $CH_3$ | (s) | (Y) |
| (37) | $t-C_4H_9$ | $CH_3$ | (o) | (Z) |
| (38) | $t-C_4H_9$ | $CH_3$ | (t) | (B) |
| (39) | $t-C_4H_9$ | $CH_3$ | (w) | (R) |
| (40) | $t-C_4H_9$ | 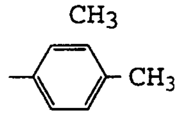 | (h) | (A) |
| (41) | $t-C_4H_9$ | 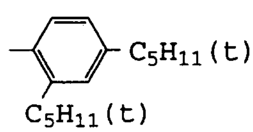 | (c) | (H) |

| No. | $R_1$ | $R_2$ | $R_3$ | Z |
|---|---|---|---|---|
| (42) | $t-C_4H_9$ | $-CH_2COOC_{12}H_{25}(n)$ | (g) | (Z) |
| (43) | $t-C_4H_9$ | 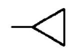 | (d) | (A) |
| (44) | 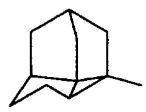 | $CH_3$ | (q) | (H) |
| (45) | $t-C_4H_9$ | $C_{16}H_{33}$ | (d) | (α) |
| (46) | $t-C_4H_9$ | $CH_3$ | (c) | (α) |
| (47) | $t-C_4H_9$ | $CH_3$ | (x) | (W) |

When the oil-in-water type emulsification method is used to add the coupler used for the light-sensitive material in the present invention, the coupler is dissolved in a water-insoluble high-boiling organic solvent having a boiling point of 150 °C or more together with, if necessary, a low-boiling organic solvent or a water-soluble organic solvent, and dispersed in a hydrophilic binder such as gelatin aqueous solutions containing a surfactant. A stirring machine, homogenizer, colloid mill, flow jet mixer and ultrasonic homogenizer can be used as a dispersion means. A process for removing the low-boiling solvent can be put after or during the dispersing process. Phosphates such as tricresyl phosphates and phthalic acid esters such as dioctyl phthalate are preferably used as the high boiling point organic solvent for dissolving and dispersing the coupler.

Further, a method can be used in which a coupler and a polymer soluble in an organic solvent and insoluble in water are dissolved in, if necessary, in a low-boiling solvent or a water-soluble solvent and dispersed in a hydrophilic binder such as gelatin solution with a surfactant by various dispersing means. As a example of polymer usable in such method includes, which is soluble in an organic solvent and insoluble in water, poly(N-t-butylacrylamide) can be cited.

Among the above solvents, compounds represented by the following Formula H are preferably used.

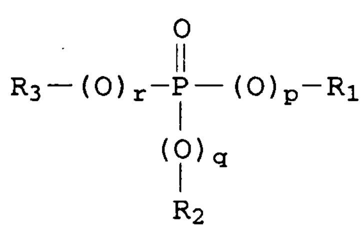

(H)

In the above formula H, $R_1$, $R_2$ and $R_3$ are each an alkyl group, a cycloalkyl group, or an aryl group; and p, q and r are each zero or 1.

Exemplified compounds

$O=P-(C_8H_{17})_3$ $O=P-(O-C_8H_{17})_3$

$O=P-(C_{12}H_{25})_3$ $O=P-(O-C_{12}H_{25})_3$

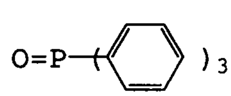

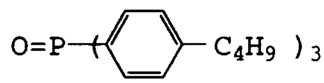

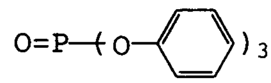

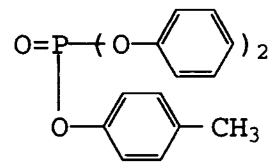

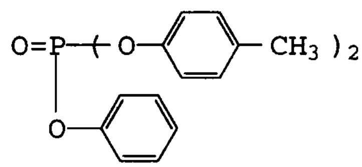

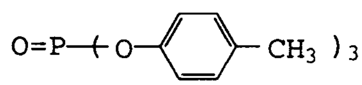

The compound such as Compound (d-11) on page 33 and Compound (A'-1) on page 35 of Japanese Patent O.P.I. Publication No. 4-114152 (1992) can be used to shift the absorption wave length of formed color dye. The fluorescent dye releasing compounds described in U.S. Patent No. 4774187 can also be used other than these.

It is advantageous to use the gelatin as a binder for the light-sensitive material in the present invention. Hydrophilic colloids other than gelatin can be used according to necessity, which include gelatin derivatives, graft polymers of gelatin and another high molecular substance, proteins other than gelatin, sugar derivatives, cellulose derivatives and synthetic hydrophilic homo- or co-polymers.

Any kinds of materials usually used as support in photographic material can be used for the light-sensitive material in the present invention which include, for instance, a paper coated with white pigment-containing polypropylene, baryta paper, vinyl chloride sheet, and a polyethylene telephthalate and a polypropylene film containing each white pigment. The white pigments usable in the support include an organic and inorganic ones. Among the above, the support having a polyolefine resin layer containing white pigments on the surface is preferable.

As the white pigment inorganic and/or organic pigments can be used. Among them inorganic pigments are preferably used, which include a sulfate of alkaline earth metal such as barium sulfate, a carbonate of alkaline earth metal such as calcium carbonate, a silica such as fine powdered silica and synthetic silica, calcium silicate, alumina, alumina hydrate, titanium oxide, zinc oxide, talc and clay.

In the above, barium sulfate and titanium oxide are preferable. The content of the white pigment in the water resistive coating on the surface of the reflecting support is preferably 10 % or more by weight, more preferably 13 % or more, further preferably 15 % by weight or more.

The dispersion degree of the white pigment in the water resistive coating of the paper support can be measured by the method described in Japanese Patent O.P.I. Publication No. 2-28640 (1990). The dispersion degree of white pigments is preferably 0.20 or less, more preferable 0.15 or less, farther preferably 0.10 or less when measured in this method.

Photographic layers of the light-sensitive material in the present invention can be coated on a support, on the surface of which may be treated with corona discharge, ultraviolet irradiation or flame, if necessary. Afterwards, it is allowed to be coated the surface of the support by one or more subbing layers to improve adhesion property of the surface of support, antistatic property, dimensional stability, abrasion resistance, hardness, anti-halation and friction characteristic/or other characteristics.

A thickener can be used to improve the coating property of the light-sensitive material. The extrusion coating by which the layer of two kinds or more can be simultaneously coated and the curtain coating are

especially useful as a coating method.

As a color developing agent usable in the method of the invention, well known primary aromatic amine color developing agent can be used. Compounds represented by the following Formula D are preferably used as the color developing agent from the view point of color reproducibility.

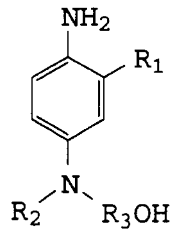

(D)

wherein $R_1$ is a hydrogen atom or an alkyl group; $R_2$ is an alkyl group; and $R_3$ is an alkylene group.

The following compound can be given as examples of these compound. These compounds are usually used in a form of salt with a acid such as sulfuric acid.

CD-1) N,N-diethyl-p-phenylenediamine
CD-2) 2-amino-5-diethylaminotoluene
CD-3) 2-amino-5-(N-ethyl-N-laulylamino)toluene
CD-4) 4-amino-3-methyl-N-ethyl-N-(β-butoxyethyl)aniline
CD-5) 2-methyl-4-{N-ethyl-N-(β-hydroxyethyl)amino}aniline
CD-6) 4-amino-3-methyl-N-ethyl-N-{β-methane-sulfonamido)-ethyl}aniline
CD-7) N-(2-amino-5-diethylaminophenylethyl)methanesulfonamide
CD-8) N,N-dimethyl-p-phenylenediamine
CD-9) 4-amino-3-methyl-N-ethyl-N-methoxyethylaniline
CD-10) 4-amino-3-methyl-N-ethyl-N-(β-ethoxyethyl)aniline
CD-11) 4-amino-N-ethyl-N-(β-hydroxyethyl)aniline

Already-known compounds as components of color developer can be added to the color developer in addition to the above mentioned color developing agent. An alkaline agent having pH buffering effect, a developing inhibitor such as chloride ion and benzotriazole, a preservative and a chelating agent are usually used.

In the method of the invention, the light-sensitive material is bleached and fixed after color development. The bleaching may be performed together with the fixing at the same time as a bleach-fixing treatment. The light-sensitive material is usually washed after fixing. A stabilizing treatment may be applied in place of washing. As processing apparatus for processing the light-sensitive material in the method of the invention, a roller transporting type processor, in which the light-sensitive material is transported between rollers, or a endless belt type processor, in which the light-sensitive material is fixed on a endless belt and transported by the belt, can be used. Furthermore, various processing mode such as a mode in which the light-sensitive material transported in a processing tank formed as slit with a processing solution flowing in the slit, a processing mode in which a processing solution is splayed to the surface of the light-sensitive material, a web processing mode in which a processing solution soaked in a web is contacted to the surface of the light-sensitive material, or a processing mode using a viscous processing solution may also be used.

In a preferable embodiment of the invention, a silver halide light-sensitive material to be used is one which gives a gradient $G_1$ within the range of from 1.7 to 2.8 when the light-sensitive material is processed by the following Condition A:

| Processing condition A | | |
|---|---|---|
| Processing step | Temperature | Time |
| Development | 35.0 ± 0.3 °C | 45 sec. |
| Bleach-fixing | 35.0 ± 0.5 °C | 45 sec. |
| Stabilizing | 30 - 34 °C | 90 sec. |
| Drying | 60 - 80 °C | 60 sec. |

| Color Developer | |
|---|---|
| Purified water | 800 ml |
| Triethanolamine | 10 g |
| N,N-diethylhydroxylamine | 5 g |
| Potassium bromide | 0.02 g |
| Potassium chloride | 2 g |
| Potassium sulfite | 0.3 g |
| 1-hydroxyethyliden-1,1-disulfonic acid | 1.0 g |
| Ethylenediaminetetraacetic acid | 1.0 g |
| Disodium catechol-3,5-disulfonate | 1.0 g |
| 4-amino-N-ethyl-N-(β-hydroxyethyl)aniline sulfate | 4.5 g |
| Fluorescent whitening agent (4,4- acid deriv,) | 1.0 g |
| Potassium carbonate | 27 g |
| Water to make to | 1 liter |
| Adjust pH to 10.60 | |

| Bleach-Fixer | |
|---|---|
| Ferric ammonium ethylenediaminetetraacetate dihydrate | 60 g |
| Ethylenediaminetetraacetic acid | 3 g |
| Ammonium thiosulfate (70 % aqueous solution) | 100 ml |
| Ammonium sulfite 940 % aqueous solution) | 27.5 ml |
| Water to make to | 1 liter |
| pH is adjusted to 5.7 with potassium carbonate or glacial acetic acid. | |

| Stabilizer | |
|---|---|
| 5-chloro-2-methyl-4-iso-thiazoline-3-on | 1.0 g |
| Ethylene glycol | 1.0 g |
| 1-hydroxyethylidene-1,1-disulfonic acid | 2.0 g |
| Ethylenediaminetetraacetic acid | 1.0 g |
| Ammonium hydroxide (20 % aqueous solution) | 3.0 g |
| Fluorescent whitening agent (4,4-diaminostilbenesulfonic acid deriv,) | 1.5 g |
| Water to make to | 1 liter |
| pH is adjusted to 7.0 with sulfuric acid or potassium hydroxide. | |

## EXAMPLES

### Example 1

On one surface of a paper support of 230 micron thick, which is coated with polyethylene containing titanium oxide and the other surface of which is coated with polyethylene, seven layers each having the following composition were provided. On the other side thereof a backing layer was provided to prepare a light-sensitive material Sample 1.

In the followings, the added amount is shown in terms of g/m$^2$. In the case of the silver halide emulsion it is given in terms of equivalent amount of silver.

| Seventh layer (Protective layer): | |
|---|---|
| Gelatin | 1.0 |
| Silica (average grain size: 3 microns) | 0.03 |
| Anti-Color Staining Agent(HQ-2) | 0.01 |
| Anti-Color Staining Agent(HQ-3) | 0.01 |

| Sixth layer (Intermediate Layer): | |
|---|---|
| Gelatin 0.4 | |
| UV absorbent (UV-1) | 0.2 |
| UV absorbent (UV-2) | 0.2 |
| UV absorbent (UV-3) | 0.2 |
| Anti-Color Staining Agent (HQ-1) | 0.01 |
| Solvent (SO-3) | 0.2 |
| Polyvinylpyrrolidone | 0.2 |
| Anti-irradiation Dye (AI-1) | 0.07 |

| Fifth layer (Red-sensitive emulsion layer): | |
|---|---|
| Gelatin | 1.3 |
| Red-sensitive chlorobromide emulsion Em-R1 optically sensitized by sensitizing dye RS-1 (AgBr 80 mol % and AgCl 20 mol %) | 0.22 |
| Cyan dye forming coupler (C-1) | 0.3 |
| Solvent (SO-1) | 0.15 |
| Anti-Color Staining Agent (HQ-1) | 0.02 |

| Fourth Layer (Intermediate Layer) | |
|---|---|
| Gelatin | 0.6 |
| Anti-Color Staining Agent (HQ-1) | 0.01 |
| Anti-Color Staining Agent (HQ-2) | 0.01 |
| Solvent (SO-3) | 0.2 |
| Anti-irradiation Dye (AI-2) | 0.01 |

| Third Layer (Green-sensitive emulsion layer): | |
|---|---|
| Gelatin | 1.2 |
| Green-sensitive chlorobromide emulsion Em-G1 optically sensitized by sensitizing dye (GS-1) (AgBr 80 mol % and AgCl 20 mol %) | 0.35 |
| Magenta Coupler (M-1) | 0.2 |
| Image tone controlling Agent (MY-1) | 0.05 |
| Anti-Color Staining Agent (HQ-1) | 0.02 |
| Solvent (SO-1) | 0.4 |

| Second Layer (Intermediate Layer): | |
|---|---|
| Gelatin | 0.6 |
| Anti-Color Staining Agent (HQ-1) | 0.02 |
| Solvent (SO-3) | 0.2 |
| Anti-irradiation Dye (AI-3) | 0.03 |

| First Layer (Blue-sensitive emulsion layer): | |
|---|---|
| Gelatin | 1.2 |
| Blue-sensitive chlorobromide emulsion Em-B1 optically sensitized by sensitizing dye (BS-1) (AgBr 80 mol % and AgCl 20 mol %) | 0.35 |
| Yellow-dye-forming Coupler (EK-Y1) | 0.4 |
| Anti-Color Staining Agent (HQ-1) | 0.02 |
| Solvent (SO-1) | 0.38 |

| Backing Layer: | |
|---|---|
| Gelatin | 6.0 |
| Silica (average grain size: 3 µm) | 0.1 |

SA-1 and SA-2 were used as a coating aid and H-1 was used as a hardener.

The chemical structures of the compounds used are shown below:

M-1

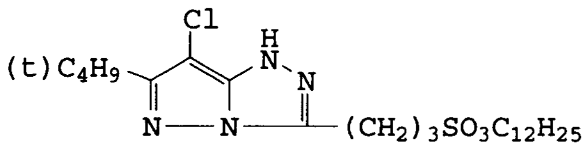

C-1

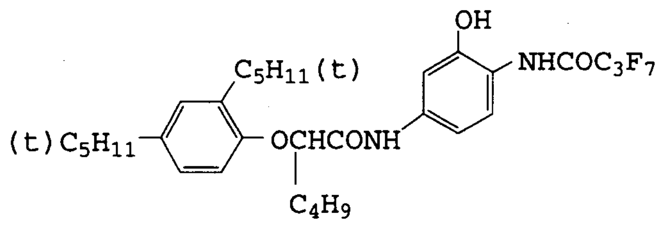

MY-1

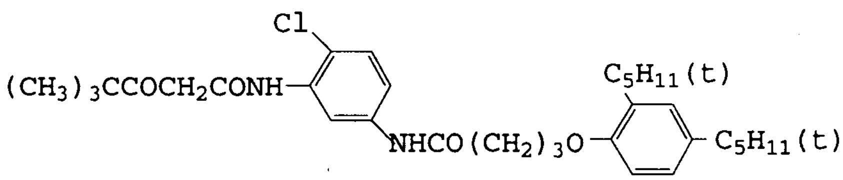

EX-Y1

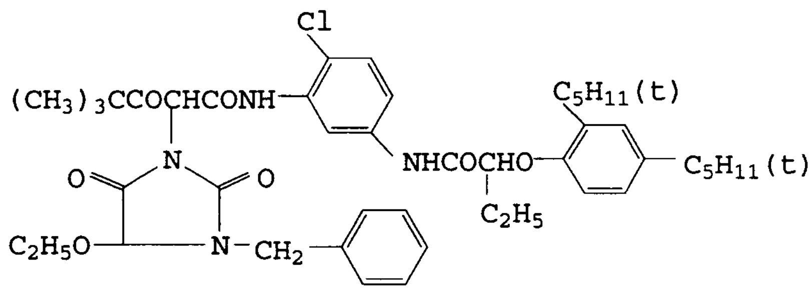

EX-Y2

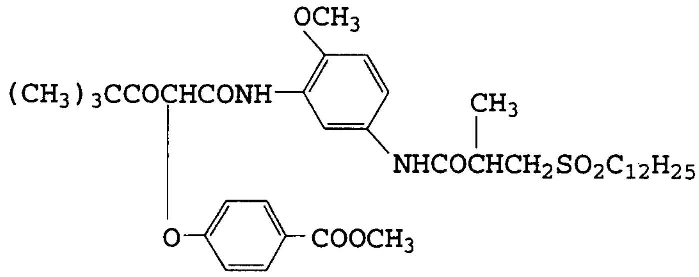

EX-Y3

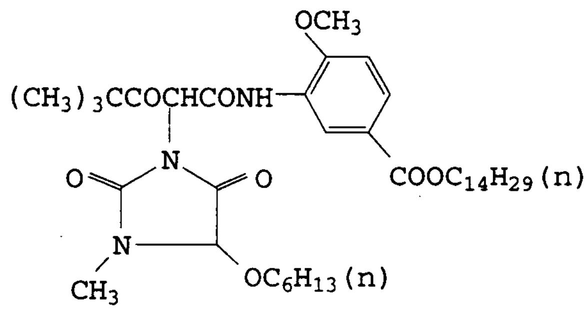

EX-Y4

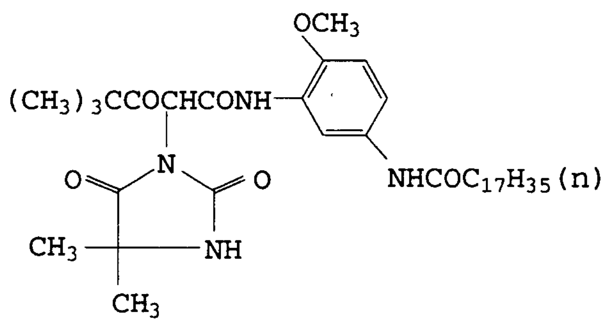

AI-1

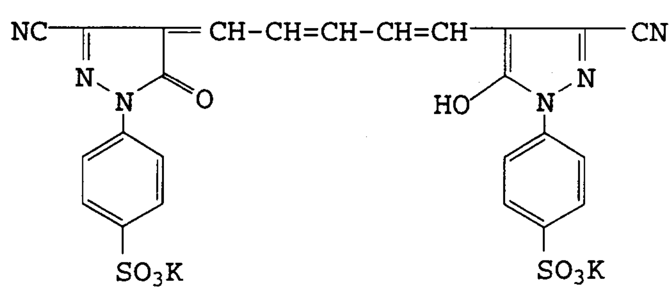

AI-2

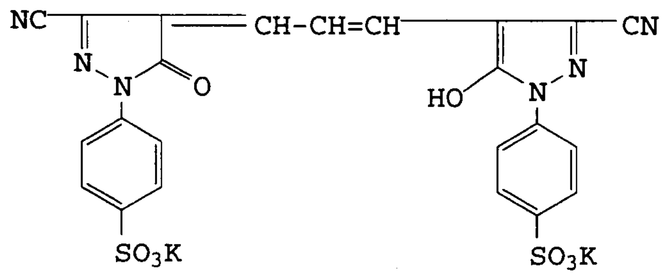

AI-3

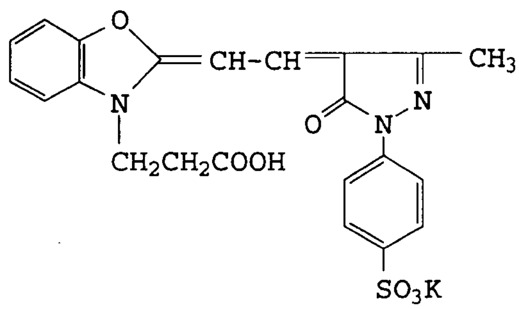

UV-1

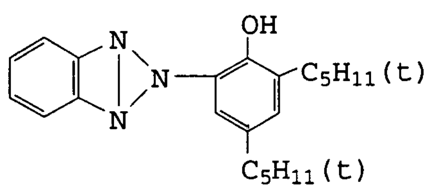

UV-2

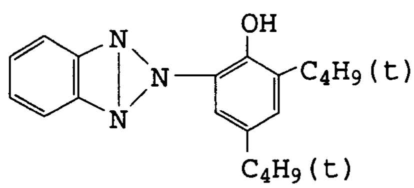

UV-3

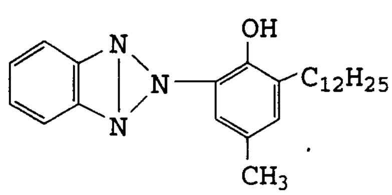

RS-1

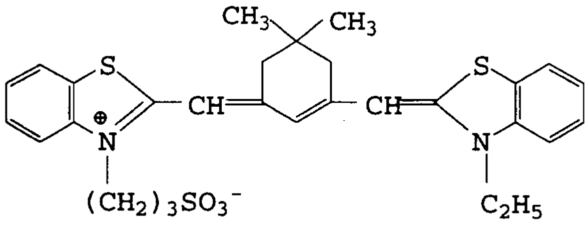

RS-2

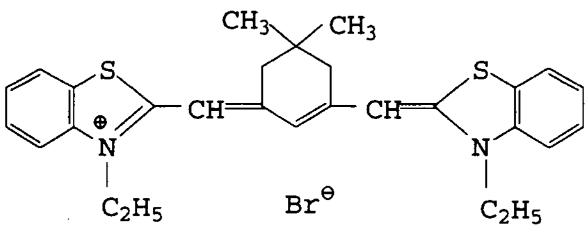

GS-1

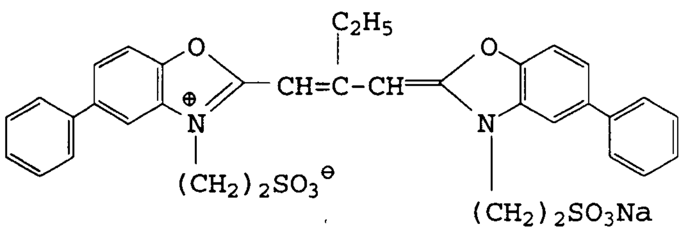

BS-1

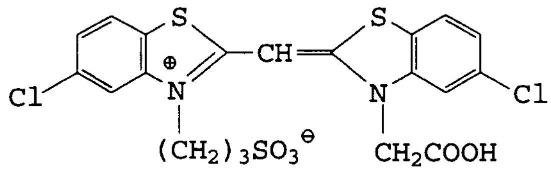

BS-2

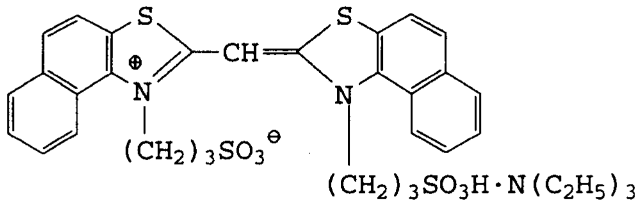

| | |
|---|---|
| PVP: | Polyvinylpyrrolidone |
| SO-1: | Trioctyl phosphate |
| SO-2: | Dioctyl phthalate |
| SO-3: | Di(2-(ethylhexyl)sebacate |
| HQ-1: | 2,5-di-t-butyl hydroquinone |

| | |
|---|---|
| HQ-2: | 2,5-di-t-octyl hydroquinone |
| HQ-3: | 2-Methyl-5-hexadecenyl hydroquinone |
| HQ-4: | 2-Methyl-5-octadecenyl hydroquinone |
| SA-1: | Disodium di(2-(ethylhexyl)sulfosuccinate |
| SA-2: | Disodium di(2,2,3,3,4,4,5,5-octafluoropentyl) sulfosuccinate |
| STAB-1: | 1-(3-acetamide)phenyl-5-mercapto tetrazole |
| H-1: | 2,4-di-chloro-6-hydroxy-s-triazine sodium salt |
| T-1: | 4-hydroxy-6-methyl-1,3,3a,7-tetrazaindene |

Furthermore, Samples 2 to 13 were prepared in the same manner as in Sample 1 except that the yellow coupler, the emulsions were changed as given in the following Table 1.

In the table, the combination of the emulsions used in the blue-, green- and red-sensitive layers are shown as follows:

| Combination of emulsion | Blue-sensitive layer | Green-sensitive layer | Red-sensitive layer |
|---|---|---|---|
| 1 | Em-B1 | Em-G1 | Em-R1 |
| 2 | Em-B2 | Em-G1 | Em-R1 |
| 3 | Em-B3 | Em-G1 | Em-R1 |
| 4 | Em-B4 | Em-G1 | Em-R1 |
| 5 | Em-B4 | Em-G2 | Em-R2 |

In Samples 1 to 5, the coating amount of each emulsion layers were changed as follows to control the gradient of the samples: 1:100%, 2:94%, 3:88%, 4:82% and 5:76%. In Samples 6 and 7, and 9 and 10, each the coating amount of the emulsion layers were changed so as to adjust the gradient thereof to the values shown in Table 1.

Sample 10 was prepared by exchanging the fifth layer with the first layer and providing the following yellow filter layer between the third layer and the fourth layer and further providing an intermediate layer between the third layer and the yellow silver colloidal layer. This sample has nine layers in all.

| Yellow filter layer: | |
|---|---|
| Gelatin | 0.42 |
| Yellow colloidal silver | 0.1 |
| Anti-color-staining agent (HQ-2) | 0.04 |
| Solvent (SO-2) | 0.049 |
| Polyvinylpyrrolidone | 0.047 |

| Intermediate layer: | |
|---|---|
| Gelatin | 0.54 |
| Anti-color mixing agent (HQ-2) | 0.055 |
| Solvent (SO-2) | 0.072 |

The emulsions used in the samples were prepared as follows:

Blue-sensitive emulsion B1

A silver chlorobromide emulsion having an average grain size of 0.7 µm and a silver bromide content of 80 mol% was prepared. The emulsion was optimally sensitized with sodium thiosulfate at 57°C. Then optical sensitizing dye BS-1 and stabilizer STB-1 were added to the emulsion to prepare blue-sensitive emulsion B1.

Green-sensitive emulsion G1

A silver chlorobromide emulsion having an average grain size of 0.5 µm and a silver bromide content of 80 mol% was prepared. The emulsion was optimally sensitized with sodium thiosulfate at 59°C. Then optical sensitizing dye GS-2 and stabilizer STB-1 were added to the emulsion to prepare green-sensitive emulsion G1.

Blue-sensitive emulsion R1

A silver chlorobromide emulsion having an average grain size of 0.4 µm and a silver bromide content of 80 mol% was prepared. The emulsion was optimally sensitized with sodium thiosulfate, a phenol resin and optical sensitizing dye RS-3 at 57°C. Then stabilizer STB-1 were added to the emulsion to prepare red-sensitive emulsion R1.

Further, blue-sensitive emulsions Em-B2, Em-B3 and Em-B4, green-sensitive emulsion Em-G2 and red-sensitive emulsion Em-R2 were prepared.

Blue-sensitive emulsion B2

Em-B2 was prepared in the same manner as in Em-B1 except that the amount of the sensitizing dye was increased 1.2 times, i.e., 70 mg to 84 mg per mol of silver.

Blue-sensitive emulsion B3

Em-B3 was prepared in the same manner as in Em-B1 except that the grain size was increased from 0.7 µm to 0.95 µm.

Blue-sensitive emulsion B4

Into 1000 ml of 2% gelatin aqueous solution, the following Solution A and Solution B were simultaneously added spending 30 minutes maintaining temperature, pAg and pH of solution at 40°C, 6.5 and 3.0, respectively. Then Solution C and Solution D were further added to simultaneously into the solution taking 180 minutes maintaining pAg and pH at 7.3 and 5.5, respectively.

At this time, pAg was controlled by the method disclosed in Japanese Patent O.P.I. Publication No. 59-45437 (1984) and pH was controlled using aqueous solution of sulfuric acid and sodium hydroxide.

| Solution A | |
|---|---|
| Sodium chloride | 3.42 g |
| Potassium bromide | 0.03 g |
| Water to make | 200 ml |

| Solution B | |
|---|---|
| Silver nitrate | 10 g |
| Water to make | 200 ml |

| Solution C | |
|---|---|
| Sodium chloride | 102.7 g |
| Potassium bromide | 1.0 g |
| Water to make | 600 ml |

| Solution D | |
|---|---|
| Silver nitrate<br>Water to make | 300 g<br>600 ml |

After completion of addition, desalting was carried out using 5 % aqueous solution of Demol N (product of Kao Atlas Co., Ltd.) and magnesium sulfate. Thus a monodisperse emulsion EMP-1 were obtained. Emulsion EMP-1 comprised cubic silver halide grains having an average grain size, coefficient of variation and silver chloride content of 0.85 μm, 0.07 and 99.5 mol%, respectively.

Emulsion EMP-1 was subjected to optimum chemical sensitization at 50°C using the following compounds to obtain a blue-sensitive emulsion Em-B4.

| | |
|---|---|
| Sodium thiosulfate | 0.8 mg/mol AgX |
| Chloroauric acid | 0.5 mg/mol AgX |
| Stabilizing agent (STAB-1) | $6x10^{-4}$ mol/mol AgX |
| Sensitizing dye (BS-1) | $4x10^{-4}$ mol/mol AgX |
| Sensitizing dye (BS-2) | $1x10^{-4}$ mol/mol AgX |

Green-sensitive emulsion Em-G2

Silver halide emulsion EMP-2 were prepared in the same manner as EMP-1 except that the adding periods of Solutions A and B, and Solution C and D were changed. Emulsion EMP-2 had an average grain size of 0.85 μm, variation coefficient of 0.07 and silver chloride content of 99.5 mol%.

Emulsion EMP-2 was chemically sensitized at 55°C using the following compounds. Thus green-sensitive emulsion Em-G2 was obtained.

| | |
|---|---|
| Sodium thiosulfate | 1.5 mg/mol AgX |
| Chloroauric acid | 1.0 mg/mol AgX |
| Stabilizing agent (STAB-1) | $6x10^{-4}$ mol/mol AgX |
| Sensitizing dye (GS-1) | $4x10^{-4}$ mol/mol AgX |

Red-sensitive emulsion Em-R2

Silver halide emulsion EMP-3 was prepared in the same manner as EMP-1 except that the adding periods of Solutions A and B, and Solution C and D were changed, and the following compounds were added to Solution C.

| | |
|---|---|
| $K_2IrCl_6$ | $3.8x10^{-8}$ mol/mol AgX |
| $K_4Fe(CN)_6$ | $1.2x10^{-5}$ mol/mol AgX |

Emulsion EMP-3 had an average grain size of 0.50 μm, variation coefficient of 0.08 and silver chloride content of 99.5 mol%.

Emulsion EMP-3 was chemically sensitized at 60°C using the following compounds. Thus red-sensitive emulsion Em-R2 was obtained.

| | |
|---|---|
| Sodium thiosulfate | 1.8 mg/mol AgX |
| Chloroauric acid | 2.0 mg/mol AgX |
| Stabilizing agent (STAB-1) | $6x10^{-4}$ mol/mol AgX |
| Sensitizing dye (RS-2) | $1x10^{-4}$ mol/mol AgX |

Thus prepared samples were exposed to blue light through an optical wedge and processed by foregoing processing procedure. The source of blue-light used here was a fluorescent lump with Wratten

Filter No. 47B manufactured by Eastman Kodak Co. The exposed samples were processed with the following Processing Condition B. In the processing, the stabilizing treatment was made by the counter-current mode consisting of two tank arrangement.

| Processing Condition B | | |
| --- | --- | --- |
| Processing step | Temperature | Time |
| Development | 35.0 ± 0.3 °C | 120 sec. |
| Bleach-fix | 35.0 ± 0.5 °C | 45 sec. |
| Stabilization | 30 - 34 °C | 90 sec. |
| Dry | 60 - 80 °C | 30 sec. |

| Developer | |
| --- | --- |
| Benzyl alcohol | 15 ml |
| $Ce_2(SO_4)_3$ | 0.015 g |
| Ethylene glycol | 8.0 ml |
| Potassium sulfite | 2.5 g |
| Potassium bromide | 0.6 g |
| Sodium chloride | 0.2 g |
| Sodium carbonate | 25.0 g |
| 4-hydroxy-6-methyl-1,3,3a,7-tetrazaindene | 0.1 g |
| Hydroxylamine sulfate | 5.0 g |
| Sodium diethylenetriamine-pentaacetate | 2.0 g |
| 4-amino-N-ethyl-N-($\beta$-hydroxyethyl)aniline sulfate | 4.5 g |
| Whitening agent(4,4'-diamino-stylbenedisulfonic acid deriv.) | 1.0 g |
| Sodium hydroxide | 2.0 g |
| Diethylene glycol | 15.0 ml |
| Water tomake | 1 l |
| Adjust pH value to 10.15 using sodium hydroxide or sulfuric acid | |

| Bleach-fixer | |
| --- | --- |
| Ferric ammonium diethylene-triaminepentaacetate | 90.0 g |
| Diethylenetriaminepenta-acetic acid | 3.0 g |
| Ammonium thiosulfate (70% aqueous solution) | 180 ml |
| Ammonium sulfite (40% aqueous solution) | 27.5 ml |
| 3-mercapto-1,2,4-triazole | 0.15 g |
| Water to make | 1 l |
| Adjust pH value to 7.1 using sodium carbonate or glacial acetic acid | |

| Stabilizer | |
|---|---|
| o-phenylphenol | 0.3 g |
| Potassium sulfite (50% aqueous solution) | 12 ml |
| Ethylene glycol | 10 g |
| 1-hydroxyethylidene-1,1'-disulfonic acid | 2.5 g |
| Bismuth chloride | 0.2 g |
| Zinc sulfate heptahydride | 0.7 g |
| Ammonium hydroxide (28% aqueous solution) | 2.0 g |
| Polyvinylpylorridone (K-17) | 0.2 g |
| Whitening agent (4,4'-diamino-stylbenedisulfonic acid deriv.) | 2.0 g |
| Water to make | 1 l |
| Adjust pH value to 7.5 using sodium hydroxide or sulfuric acid | |

Each of the processed test pieces of the samples was subjected to densitometry with blue light and characteristic curves of the blue-sensitive emulsion layer or yellow image was drawn in an ordinary manner by Densitometer PD-84 manufactured by Konica Corporation. The gradients $G_1$ and $G_2$ of the characteristic curve were determined according to the foregoing definition. The processed piece prepared was further subjected densitometry with green light and red light and characteristic curves of green-sensitive layer or magenta image and red-sensitive layer or cyan image, and the characteristic curves were drawn. From thus obtained curves and the curves of blue-sensitive layer obtained in the above, sensitivities of these three layers to blue light, $(S_B)_B$, $(S_G)_B$ and $(S_R)_B$ were determined. Thus $(S_G)_B/(S_B)_B$ and $(S_R)_B/(S_B)$ where calculated. In the above, densitometry was carried out by Densitometer PD-84 manufactured by Konica Corporation.

On the other hand the color failure caused by dot gain control was determined by the following procedure.

A half of a test piece of the sample is covered with a negative film having an uniform dot image of 133 lines/inch with dot percentage of 50 % and the other half was not covered and the piece was exposed uniformly exposed to the following blue light so that the dot percent of the printed dot image to be 72 %. Further, a piece of the sample was exposed in the same manner as above except that the exposure amount was increased so that the dot percentage was increased to 75 %, i.e., dot gain increased by 3 %. The blue light source used was the same as that used in the above gradient determination. The uniformly exposed part, i.e., the part exposed without dot image negative of each pieces, was subjected to colorimetry by Color Differential Colorimeter CR-121 manufactured by Minoruta Co., Ltd. Thus obtained colorimetry data of hue were plotted on a L*a*b* chromaticity chart according to the standard of CIE and JIS (Japanese Industrial Standard) Z-8727, and differences in the angle of the plotted positions of the hue on the a*b* plane of the chromaticity chart $\Delta\theta$ and in the brightness $\Delta L$ between the test piece having dots of 72 % and that having dots of 75 %, $\Delta\theta$ and $\Delta L$ were determined. Larger value of these difference are corresponding larger deterioration in yellow color of proof caused by increasing in exposure amount for obtaining the dot gain of 3 %. Further a solid yellow image density of the uniformly exposed area of the test piece having 75 %-dot image. The solid yellow density is usually required to be within the range of 0.96 to 1.09 in actual proof making process.

Further, Samples 11 to 13 were identically evaluated except that the color developing agent CD-11 was replaced by developing agent CD-2.

Table 1

| No. | Sample No. | Combination of emulsion | Yellow filter layer | Yellow coupler | Color developing agent | $G_1$ | $G_2$ | SG/SB | SR/SB | Solid density | Δθ | ΔL | |
|---|---|---|---|---|---|---|---|---|---|---|---|---|---|
| 1 | 1 | Em-1 | None | EX-Y1 | CD-2 | 3.30 | 2.80 | 0.128 | 0.122 | 1.15 | 2.88 | 2.45 | Comparative |
| 2 | 2 | Em-1 | None | EX-Y1 | CD-2 | 2.60 | 2.10 | 0.130 | 0.123 | 1.08 | 4.02 | 3.88 | Comparative |
| 3 | 3 | Em-1 | None | EX-Y1 | CD-2 | 2.00 | 1.70 | 0.127 | 0.119 | 1.05 | 4.33 | 4.10 | Comparative |
| 4 | 4 | Em-1 | None | EX-Y1 | CD-2 | 1.80 | 1.60 | 0.128 | 0.122 | 1.02 | 4.50 | 4.12 | Comparative |
| 5 | 5 | Em-1 | None | EX-Y1 | CD-2 | 1.60 | 1.18 | 0.128 | 0.122 | 0.90 | 4.80 | 4.40 | Comparative |
| 6 | 6 | Em-2 | None | EX-Y1 | CD-2 | 1.60 | 1.18 | 0.089 | 0.085 | 0.90 | 2.80 | 2.20 | Comparative |
| 7 | 7 | Em-2 | None | EX-Y1 | CD-2 | 2.00 | 1.60 | 0.089 | 0.085 | 1.04 | 2.02 | 2.02 | Inventive |
| 8 | 8 | Em-3 | None | EX-Y1 | CD-2 | 2.10 | 1.80 | 0.095 | 0.091 | 1.06 | 2.30 | 2.34 | Inventive |
| 9 | 9 | Em-3 | None | EX-Y2 | CD-2 | 3.30 | 2.70 | 0.095 | 0.091 | 1.17 | 2.22 | 2.18 | Comparative |
| 10 | 10 | Em-3 | None | EX-Y2 | CD-2 | 2.10 | 1.75 | 0.095 | 0.091 | 1.06 | 2.28 | 2.29 | Inventive |
| 11 | 11 | Em-4 | None | EX-Y2 | CD-2 | 2.05 | 1.70 | 0.063 | 0.060 | 1.04 | 1.70 | 1.78 | Inventive |
| 12 | 12 | Em-1 | With | EX-Y2 | CD-2 | 2.00 | 1.68 | 0.065 | 0.061 | 1.02 | 1.95 | 1.85 | Inventive |
| 13 | 13 | Em-5 | None | EX-Y3 | CD-2 | 2.20 | 1.85 | 0.063 | 0.060 | 1.06 | 1.78 | 1.80 | Inventive |
| 14 | 14 | Em-5 | None | EX-Y4 | CD-2 | 2.20 | 1.85 | 0.063 | 0.060 | 1.06 | 1.75 | 1.80 | Inventive |
| 15 | 15 | Em-5 | None | EX-Y2 | CD-11 | 2.20 | 1.85 | 0.063 | 0.060 | 1.06 | 1.45 | 1.60 | Inventive |
| 16 | 13 | Em-5 | None | EX-Y3 | CD-11 | 2.20 | 1.85 | 0.063 | 0.060 | 1.06 | 1.46 | 1.63 | Inventive |
| 17 | 14 | Em-5 | None | EX-Y4 | CD-11 | 2.20 | 1.85 | 0.063 | 0.060 | 1.06 | 1.30 | 1.60 | Inventive |

As shown in Table 1, it is understood that when the sensitivity difference becomes 10 times or more and $G_1$ is within the range of the claimed value, difference in color hue and lowering in the brightness of color caused by increasing in exposure becomes small.

Example 2

Samples 14 to 16 prepared in Example 1 were evaluated in the same manner as in Example 1 except that the samples were processed with the foregoing processing condition A after exposure. Thus test results listed in the following Table 2 were obtained.

Table 2

| No. | Sample No. | Combination of emulsion | Yellow filter layer | Yellow coupler | Color developing agent | $G_1$ | $G_2$ | SG/SB | SR/SB | Solid density | Δθ | ΔL | |
|---|---|---|---|---|---|---|---|---|---|---|---|---|---|
| 18 | 13 | Em-5 | None | EX-Y3 | CD-11 | 2.25 | 1.90 | 0.061 | 0.058 | 1.06 | 1.44 | 1.60 | Inventive |
| 19 | 14 | Em-5 | None | EX-Y3 | CD-11 | 2.24 | 1.90 | 0.060 | 0.058 | 1.06 | 1.42 | 1.58 | Inventive |
| 20 | 15 | Em-5 | None | EX-Y4 | CD-11 | 2.25 | 1.90 | 0.060 | 0.058 | 1.06 | 1.40 | 1.55 | Inventive |

Example 3

A blue-sensitive emulsion Em-B5, a green-sensitive emulsion Em-G3 and a red-sensitive emulsion Em-R3 were each prepared in the same manner as in Em-B4, Em-G2 and Em-R2, respectively, except that the sensitizing dyes were increased in 10 % to raise the sensitivity of each emulsion.

Samples 16 to 18 were prepared in the same manner as in Sample 13 except that the emulsions Em-B4, Em-G2 and Em-R2 were replace by Em-B5, Em-G3 and Em-R3 and the coating amounts thereof were changed in Sample 17 and 18 so as to adjust the gradient to the value given in the following Table 3. In Samples 19 to 23, mixtures of Em-B4 and Em-B5, Em-G2 and Em-G3, and Em-R2 and Em-R3 were in the blue-. green- and red-sensitive emulsion layers, respectively. The mixing ratio of the emulsions were changed in the each samples to adjust the gradients of the samples to the values given in Table 3.

The samples were evaluated in the same manner as in Example 1 except that Processing was carried out with Processing Condition A. Further, the samples were subjected to sensitometry using green light through Wratten Filter 61, product of Eastman Kodak, or red light through Wratten Filter 29 to determined the gradient of the green-sensitive layer or red-sensitive layer. Thus obtained results are listed in Table 3. In the table, $D_R$, $D_G$, $D_B$ and $D_K$ are each a solid density of the sample uniformly exposed to red light, green light, blue light and white light respectively. The amount of each light of the uniform exposure was the same as that necessary to form a dot image with dot gain 22 %, i.e., to form 72 % dot image from an original having 50 % dot image. The density of $D_R$, $D_G$, $D_B$ and $D_K$ were measure by densitometry with red, green, blue and white light, respectively, in the ordinary manner. The data with parenthesizes in the columns of $D_R$, $D_G$, $D_B$ and $D_K$ are each a difference in the density caused by increasing exposure so as to raise the dot gain further 3 %.

Table 3

| Sample No. | G1 R | G1 G | G1 B | G2 R | G2 G | G2 B | SG/SB | SR/SB | DR | DG | DB | DK | Δθ | ΔL | |
|---|---|---|---|---|---|---|---|---|---|---|---|---|---|---|---|
| Standard density | | | | | | | | | 1.29 | 1.38 | 1.03 | 1.60 | | | |
| 18 | 3.30 | 3.00 | 2.80 | 2.80 | 2.60 | 2.13 | 0.063 | 0.060 | 1.69 | 1.53 | 1.10 | 1.68 | 1.46 | 1.7 | Comp. |
| | | | | | | | | | (0.40) | (0.15) | (0.07) | (0.08) | | | |
| 19 | 2.24 | 2.21 | 2.10 | 1.75 | 1.73 | 1.70 | 0.063 | 0.060 | 1.28 | 1.37 | 1.01 | 1.53 | 1.5 | 1.73 | Inv. |
| | | | | | | | | | (0.01) | (0.01) | (0.02) | (0.07) | | | |
| 20 | 1.75 | 1.74 | 1.72 | 1.40 | 1.41 | 1.37 | 0.063 | 0.063 | 1.10 | 1.22 | 0.87 | 1.50 | 1.45 | 1.66 | Inv. |
| | | | | | | | | | (0.19) | (0.16) | (0.16) | (0.10) | | | |
| 21 | 2.20 | 2.20 | 2.10 | 2.20 | 2.10 | 2.20 | 0.040 | 0.038 | 1.29 | 1.38 | 1.03 | 1.62 | 1.43 | 1.38 | Inv. |
| | | | | | | | | | (0.00) | (0.00) | (0.00) | (0.02) | | | |
| 22 | 2.45 | 2.40 | 2.38 | 2.25 | 2.20 | 2.18 | 0.042 | 0.038 | 1.31 | 1.41 | 1.05 | 1.63 | 1.44 | 1.40 | Inv. |
| | | | | | | | | | (0.02) | (0.03) | (0.02) | (0.03) | | | |
| 23 | 1.95 | 1.80 | 1.90 | 1.90 | 2.00 | 1.90 | 0.043 | 0.039 | 1.27 | 1.36 | 1.00 | 1.60 | 1.45 | 1.40 | Inv. |
| | | | | | | | | | (0.02) | (0.02) | (0.03) | (0.00) | | | |
| 24 | 2.50 | 2.10 | 1.90 | 1.90 | 2.00 | 1.90 | 0.043 | 0.040 | 1.32 | 1.38 | 1.00 | 1.60 | 1.45 | 1.41 | Inv. |
| | | | | | | | | | (0.03) | (0.00) | (0.03) | (0.00) | | | |
| 25 | 2.10 | 2.05 | 2.02 | 2.40 | 2.00 | 1.90 | 0.043 | 0.040 | 1.29 | 1.37 | 1.02 | 1.61 | 1.46 | 1.41 | Inv. |
| | | | | | | | | | (0.00) | (0.01) | (0.01) | (0.01) | | | |

Comp.: Comparative Inv.: Inventive
R: Red-sensitive layer G: Green-sensitive layer B: Blue sensitive layer

Samples having a shouulder gradient $G_2$ not lower than 1.8 give images excellent in reproduction of black color.

## Claims

1. A method for making a color proof comprising the steps of

   dot-imagewise exposing a silver halide color photographic light-sensitive material comprising a reflective support having thereon a blue-sensitive silver halide emulsion layer containing a yellow color forming coupler, a green-sensitive silver halide emulsion layer containing a magenta color forming coupler and a red-sensitive silver halide emulsion containing a cyan color forming coupler, to blue-light to form a yellow halftone dot image, and

   developing said exposed light-sensitive material with a color developer,

   wherein the sensitivity to said blue-light of said green-sensitive emulsion layer $(S_G)_B$ and that of said blue-sensitive emulsion layer $(S_B)_B$, and the sensitivity to said blue-light of said red-sensitive emulsion layer $(S_R)_B$ and that of said blue-sensitive emulsion layer $(S_B)_B$ each have the following relation,

   $(S_G)_B/(S_B)_B \leqq 1/10$ and $(S_R)_B/(S_B)_B \leqq 1/10$, and

   the gradient $G_1$ of a straight line connecting a density point of (minimum density + 0.5) and a density point of (minimum density + 1.1) on the photographic characteristic curve of the yellow image formed on said light-sensitive material processed by the above processing is within the range of from 1.7 to 2.8.

2. The method of claim 1, wherein the wavelength of said blue-light is within the range of 350 nm to 500 nm.

3. The method of claim 1, wherein said gradient $G_1$ is within the range of from 2.0 to 2.6.

4. The method of claim 1, wherein the gradient $G_2$ of a straight line connecting a density point of (minimum density + 1.4) and a density point of (minimum density + 1.7) on said characteristic curve is not lower than 1.8.

5. The method of claim 1, wherein said light-sensitive material is one giving a gradient $G_1$ of 1.8 to 2.8 when the material is processed by the following Processing Condition A:

| Processing condition A | | |
|---|---|---|
| Processing step | Temperature | Time |
| Development | 35.0 ± 0.3 °C | 45 sec. |
| Bleach-fixing | 35.0 ± 0.5 °C | 45 sec. |
| Stabilizing | 30 - 34 °C | 90 sec. |
| Drying | 60 - 80 °C | 60 sec. |

| Color Developer | |
|---|---|
| Purified water | 800 ml |
| Triethanolamine | 10 g |
| N,N-diethylhydroxylamine | 5 g |
| Potassium bromide | 0.02 g |
| Potassium chloride | 2 g |
| Potassium sulfite | 0.3 g |
| 1-hydroxyethyliden-1,1-disulfonic acid | 1.0 g |
| Ethylenediaminetetraacetic acid | 1.0 g |
| Disodium catechol-3,5-disulfonate | 1.0 g |
| 4-amino-N-ethyl-N-($\beta$-hydroxyethyl)aniline sulfate | 4.5 g |
| Fluorescent whitening agent (4,4-diaminostilbenesulfonic acid deriv,) | 1.0 g |
| Potassium carbonate | 27 g |
| Water to make to | 1 liter |
| Adjust pH to 10.60 | |

| Bleach-Fixer | |
|---|---|
| Ferric ammonium ethylenediaminetetraacetate dihydrate | 60 g |
| Ethylenediaminetetraacetic acid | 3 g |
| Ammonium thiosulfate (70 % aqueous solution) | 100 ml |
| Ammonium sulfite 940 % aqueous solution) | 27.5 ml |
| Water to make to | 1 liter |
| pH is adjusted to 5.7 with potassium carbonate or glacial acetic acid. | |

| Stabilizer | |
|---|---|
| 5-chloro-2-methyl-4-iso-thiazoline-3-on | 1.0 g |
| Ethylene glycol | 1.0 g |
| 1-hydroxyethylidene-1,1-disulfonic acid | 2.0 g |
| Ethylenediaminetetraacetic acid | 1.0 g |
| Ammonium hydroxide (20 % aqueous solution) | 3.0 g |
| Fluorescent whitening agent (4,4-diaminostilbenesulfonic acid deriv,) | 1.5 g |
| Water to make to | 1 liter |
| pH is adjusted to 7.0 with sulfuric acid or potassium hydroxide. | |

**6.** The method of claim 1, wherein said blue-sensitive emulsion layer, green-sensitive emulsion layer and red-sensitive emulsion layer each comprise silver halide grains having a silver chloride content of not lower than 80 mole %.

**7.** The method of claim 1, wherein said yellow coupler contained in the blue sensitive emulsion layer is one represented by the following formula Y:

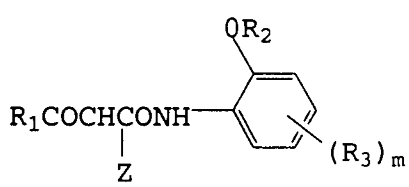

(Y)

wherein $R_1$ is an alkyl group or a cycloalkyl group; $R_2$ is an alkyl group, a cycloalkyl group or an aryl

group; $R_3$ is a group capable of being a substituent of the benzene ring; m is an integer of 0 to 4; provided $R_3$s may be the same or different when m is 2 to 4; and Z is a hydrogen atom or a substituent capable of releasing upon reaction with the oxidation product of a color developing agent.

**8.** The method of claim 1, wherein at least one of said light-sensitive material contains a high-boiling organic solvent represented by the following formula H:

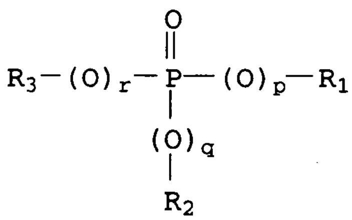

(H)

wherein the above formula H, $R_1$, $R_2$ and $R_3$ are each an alkyl group, a cycloalkyl group, or an aryl group; and p, q and r are each zero or 1.

**9.** The method of claim 1, wherein said color developer contains a color developing agent represented by the following formula D;

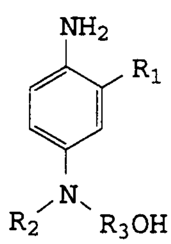

(D)

wherein $R_1$ is a hydrogen atom or an alkyl group; $R_2$ is an alkyl group; and $R_3$ is an alkylene group.